(19) Europäisches Patentamt
European Patent Office
Office européen des brevets

(11) **EP 4 386 395 A1**

(12) **EUROPEAN PATENT APPLICATION**

(43) Date of publication:
**19.06.2024 Bulletin 2024/25**

(21) Application number: **23210692.2**

(22) Date of filing: **17.11.2023**

(51) International Patent Classification (IPC):
**G01R 31/26** (2020.01)          **G01R 31/28** (2006.01)
**G01R 31/42** (2006.01)

(52) Cooperative Patent Classification (CPC):
**G01R 31/42; G01R 31/2621; G01R 31/2642;
G01R 31/2817**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.12.2022 GB 202218690**

(71) Applicant: **Rolls-Royce plc
London N1 9FX (GB)**

(72) Inventors:
• **Mohamed Halick, Mohamed Sathik
  Derby, DE24 8BJ (GB)**
• **Nadarajan, Sivakumar
  Derby, DE24 8BJ (GB)**
• **Vaiyapuri, Viswanathan
  Derby, DE24 8BJ (GB)**
• **Gupta, Amit
  Derby, DE24 8BJ (GB)**

(74) Representative: **Rolls-Royce plc
Moor Lane (ML-9)
PO Box 31
Derby DE24 8BJ (GB)**

(54) **A METHOD OF MONITORING A HEALTH STATE OF A POWER SEMICONDUCTOR DEVICE**

(57)  There is disclosed a method of monitoring a health state of a power semiconductor device (10), the method comprising: receiving an initial transient voltage parameter relating to a transient voltage of the power semiconductor device when turning on, when the power semiconductor device is known to be unaged; receiving an initial transient current parameter relating to a transient current of the power semiconductor device when turning on, when the power semiconductor device is known to be unaged; determining an initial energy parameter, relating to an initial turn-on switching energy or power of the power semiconductor device, when the power semiconductor device is known to be unaged, based on the initial transient voltage parameter and the initial transient current parameter; receiving an operating transient voltage parameter relating to the transient voltage of the power semiconductor device in operation; receiving an operating transient current parameter relating to the transient current of the power semiconductor device in operation; determining an operating energy parameter, relating to the turn-on switching energy or power of the power semiconductor device in operation, based on the operating transient voltage parameter and the operating transient current parameter; and determining the health state of the power semiconductor device based on the initial energy parameter and the operating energy parameter.

Figure 1

**Description**

The present disclosure relates to a method of monitoring a health state of a power semiconductor device and an external circuit for connecting to a power semiconductor device.

Power semiconductor devices are an integral part of power and propulsion systems in aerospace, marine and land-based applications. However, due to the fact that the power semiconductor devices are exposed to electrical, thermal and mechanical stresses during their operation, the failure rates of these components are common and affect reliability of the whole system.

According to a first aspect there is provided a method of monitoring a health state of a power semiconductor device, the method comprising:

> receiving an initial transient voltage parameter relating to a transient voltage of the power semiconductor device when turning on, when the power semiconductor device is known to be unaged;
>
> receiving an initial transient current parameter relating to a transient current of the power semiconductor device when turning on, when the power semiconductor device is known to be unaged;
>
> determining an initial energy parameter, relating to an initial turn-on switching energy or power of the power semiconductor device, when the power semiconductor device is known to be unaged, based on the initial transient voltage parameter and the initial transient current parameter;
>
> receiving an operating transient voltage parameter relating to the transient voltage of the power semiconductor device in operation;
>
> receiving an operating transient current parameter relating to the transient current of the power semiconductor device in operation;
>
> determining an operating energy parameter, relating to the turn-on switching energy or power of the power semiconductor device in operation, based on the operating transient voltage parameter and the operating transient current parameter; and
>
> determining the health state of the power semiconductor device based on the initial energy parameter and the operating energy parameter.

An unaged power semiconductor device may be a power demiconductor device which is new or near new and functional. An aged power semiconductor device may be one which is no longer functional or close to failing.

It may be that the health state of the power semiconductor device is determined to be aged if the operating energy parameter is above a threshold, the threshold being determined based on the initial energy parameter.

It may be that the threshold is at least 20% higher than the initial energy parameter.

It may be that the method further comprises: receiving an initial load parameter when the power semiconductor device is known to be unaged, receiving an operating load parameter parameter during operation of the power semiconductor device; wherein the initial energy parameter is normalised based on the initial load parameter and the operating energy parameter is normalised based on the operating load parameter.

It may be that the load parameter comprises at least one of: a temperature parameter relating to a temperature of the power semiconductor device; a predetermined load voltage parameter relating to a load voltage which is applied to the power semiconductor device; and a predetermined load current parameter relating to a load current which is applied to the power semiconductor device.

It may be that the (i) initial energy parameter and the (ii) operating energy parameter are based respectively on (i) digitally integrating initial transient current parameter and initial transient voltage parameter and on (ii) digitally integrating operating transient current parameter and operating transient voltage parameter.

It may be that the operating energy parameter is determined by:

> integrating turn-on switching power, based on the respective transient current parameter and transient voltage parameter, over a predetermined time period, to derive turn-on switching energy;
>
> dividing the turn-on switching energy by a number of load current cycles over the predetermined time period to obtain a load cycle energy parameter, relating to an average energy loss for each load current cycle; and
>
> basing the operating energy parameter on the average energy loss for each load current cycle.

It may be that basing the operating energy parameter on the average energy loss for each load current cycle comprises, identifying a plurality load cycle energy parameters over a predetermined time period, and basing the operating energy parameter on a peak load cycle energy parameter from the plurality of load cycle energy parameters, relating to a peak value of average energy loss for each load current cycle during the predetermined time period.

It may be that the method further comprises determining a remaining useful life of the power semiconductor device based on the initial energy parameter and the operating energy parameter, using a machine learning algorithm which has been trained with experimental data of energy parameter variation over a lifecycle of sample power semiconductor devices.

According to a second asecpt, there is provided an external circuit for connecting to a power semiconductor device, the external circuit comprising: a rogowski coil for measuring transient current; an analog isolator connected to a voltage sensor; a processor configured receive signals from the analog isolator and the rogowski coil and to perform a method in accordance with the first aspect based on the received signals.

It may be that the external circuit further comprises a gate driver configured to be connected between the analog isolator and a gate of the power semiconductor device, and configured to trigger initiation of voltage monitoring and current monitoring when the circuit is turned on.

It may be that the external circuit further comprises a digital integration field-programmable gate array configured to receive signals from the analog isolator, and to integrate the signals for processing by the processor.

It may be that the external circuit further comprises at least one temperature sensor configured to monitor the temperature of a case of the semiconductor device, and to deliver a signal indicative of the temperature of the case to the processor.

The skilled person will appreciate that except where mutually exclusive, a feature described in relation to any one of the above aspects may be applied mutatis mutandis to any other aspect. Furthermore, except where mutually exclusive any feature described herein may be applied to any aspect and/or combined with any other feature described herein.

Embodiments will now be described by way of example only, with reference to the Figures, in which:

**Figure 1** is a circuit diagram showing an external circuit connected to a power semiconductor device;

**Figure 2** is a flow chart showing steps of a method of monitoring a health state of the power semiconductor device;

**Figure 3** is a flow chart showing steps of a method of determining an operating energy parameter for the method shown in Figure 2; and

**Figure 4** is a flow chart showing further detailed steps of the method of determining a health status of the semiconductor device of Figure 1.

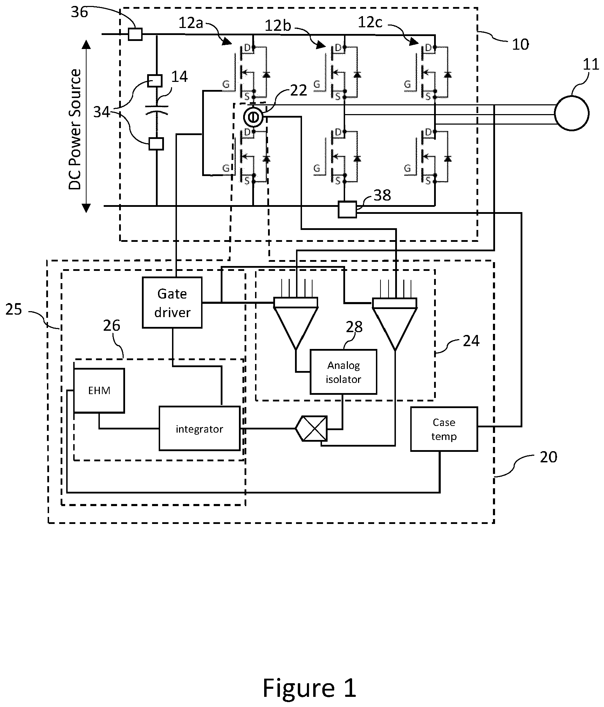

**Figure 1** shows a semiconductor device in the form of an inverter 10, configured to be connected to a DC power source, and connected to a three-phase power consuming device 11, and an external circuit 20.

In this example, the inverter 10 is a 3-phase inverter comprising six transistors 12, in this example metal-oxide semiconductor field-effect transistors 12 (MOSFETs). In other examples, the inverter may have any suitable number of phases and a corresponding number of transistors. In other examples, the inverter may have other types of transistors.

In this example, the transistors 12 are arranged in three parallel pairs, a first transistor pair 12a, a second transistor pair 12b, and a third transistor pair 12c, where each pair of transistors act in complimentary states, such that only one of a respective pair of transistors is switched on at any one time. Each phase of the three-phase power consuming device 11 is connected between a respective transistor pair 12. The inverter 10, in this example, also comprises a capacitor 14 in parallel with each pair of the transistors 12a, 12b, 12c.

The external circuit 20 comprises a Rogowski coil 22 which, in this example, is connected to the inverter 10 between the first transistor pair 12a. In other examples, the Rogowski coil 22 may be connected to the inverter between any of the transistor pairs 12a, 12b, 12c. The Rogowski coil 22 is configured to measure a switching current of the semiconductor device 10, and in this example is connected to an isolator circuit 24 comprising an analog isolator 28. The Rogowski coil 22 therefore provides a transient current parameter, $I_t$, to the isolator circuit 24.

The isolator circuit 24 is also directly connected to the same point between the first transistor pair 12a, and comprises a voltage sensor in the analog isolator 28, to measure a voltage across the first transistor pair 12a. The voltage sensor 30 therefore provides a transient voltage parameter, $V_t$ to the isolator circuit 24.

The isolator circuit 24 is connected to a processor 25 including a digital integration circuit 26 so that the transient current parameter, $I_t$, signal from the Rogowski coil 22 and the transient voltage parameter, $V_t$ from the voltage sensor 30 are passed through the digital integration circuit 26. The digital integration circuit 26 is configured to multiply the transient current parameter, $I_t$ received from the Rogowski coil 22, and transient voltage, $V_t$ received from the voltage sensor 30, together (for example in a multiplier) to obtain a transient power signal relating to turn on switching power, $P_t$:

$$P_t = I_t V_t \qquad \text{Equation (1)}$$

The digital integration circuit 26 in this example, comprises a digital integration field-programmable gate array which is configured to integrate the transient power signal, $P_t$, to obtain an energy parameter, $E$, relating to the turn-on switching energy of the semiconductor device 10 over a predetermined period of time.

$$E = \int P_t \, dt \qquad \text{Equation (2)}$$

$$E = \int I_t V_t \, dt \qquad \text{Equation (3)}$$

It has been found that the turn-on switching energy of a power semiconductor device 10 changes dependent on the age of the device. For example, a new or unaged (e.g., near new and functional) semiconductor device 10 has a lower turn-on switching energy than an aged semiconductor device 10. Therefore, the energy parameter, $E$, derived using the external circuit 20 can be used to determine a health state of the semiconductor device 10 to which it is connected.

It has been found that the turn-on switching energy is sensitive to a load applied to the semiconductor device 10. For example, the turn-on switching energy varies dependent on the load voltage applied, the load current applied and the temperature of the case of the semiconductor device. Therefore, in this example, the external circuit 20 comprises a further load voltage sensor 34 configured to measure the voltage across the capacitor 14 to measure the load voltage, and a load current sensor 36 connected at the DC link to measure the load current. The external circuit 20 further comprises a temperature sensor 38 configured to monitor a temperature of a casing of the inverter 10.

In this example, the energy parameter may be normalised to derive a normalised energy parameter, $E_N$, with a load parameter such as a load voltage, load current and/or casing temperature. The energy parameter, $E$, may be normalised with a temperature correction coefficient $T_c$, based on a temperature parameter from the temperature sensor 38, a voltage correction coefficient, $Vd_c$, based on a load voltage parameter from the load voltage sensor 34, and a current correction coefficient, $Id_c$, based on a load current parameter from the load current sensor 36.

$$E_N = E \times Vd_c \times Id_c \times T_c \qquad \text{Equation (4)}$$

The variation in turn-on switching energy for any particular type of semiconductor device based on the temperature, voltage or current applied may vary. Therefore, for any particular semiconductor device type, the respective correction coefficients may be experimentally derived.

The external circuit 20 comprises a gate driver 42 which is configured to be connected between the isolator circuit 24 and the gates of the first transistor pair 12a of the inverter 10. The gate driver 42 may be connected to the gates of whichever transistor pair 12 the Rogowski coil 22 is connected between. The gate driver 42 is configured to trigger initiation of voltage monitoring and current monitoring when the circuit is turned on, and the processing of the signals to derive the normalised energy parameter, $E_N$.

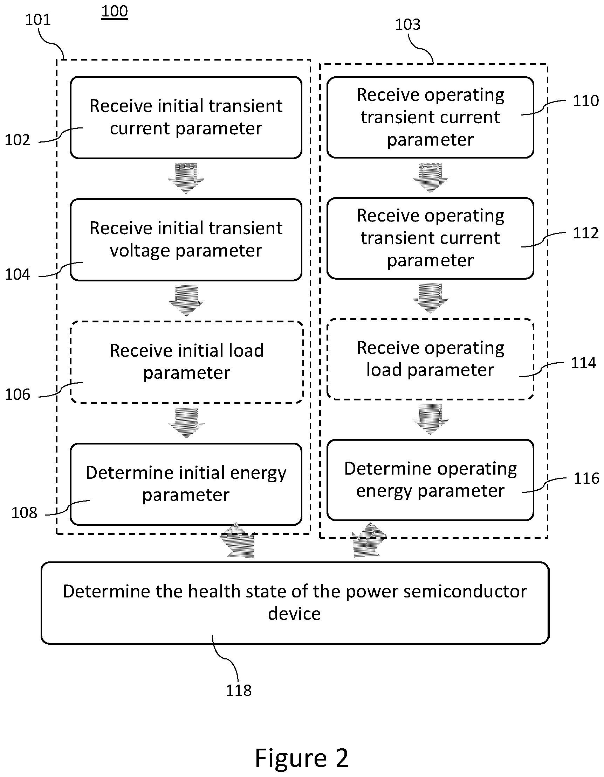

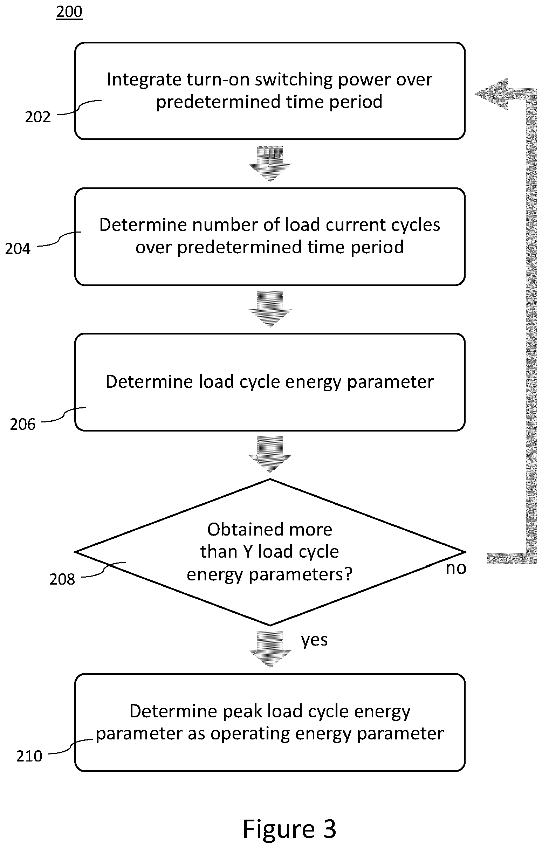

A method carried out by the processor 25 will be explained in more detail below with reference to Figures 2 and 3, below.

**Figure 2** is a flow chart showing steps of a method 100 of monitoring a health state of the inverter 10, or any suitable power semiconductor device.

In block 101, parameters are received and processed in an initial phase, when the when the inverter 10 is known to be new or unaged. In block 103, parameters are received and processed in an operating phase, at a later time than the initial phase, when the health state of the power semiconductor device 10 is not known.

Within block 101, are blocks 102 to 108. In block 102, the method 100 comprises receiving an initial transient current parameter, $I_{t,i}$, for example from the Rogowski coil 22 in Figure 1, relating to the transient current of the inverter 10 when turning on, when the inverter 10 is known to be new or unaged.

In block 104, the method 100 comprises receiving an initial transient voltage parameter, $V_{t,i}$, for example from the voltage sensor 30 in Figure 1, relating to the transient voltage of the inverter 10 when turning on, when the inverter 10 is known to be new or unaged.

In block 106, the method 100 may comprise receiving an initial load parameter, which may include a temperature parameter, a load voltage parameter and/or a load current parameter. The initial load parameter in this example includes an initial load current correction coefficient, $Id_{c,i}$, an initial load voltage correction coefficient, $Vd_{c,i}$, and an initial temperature correction coefficient $T_{c,i}$. In some examples, the method 100 may skip block 106, and thereby not include receiving an initial load parameter.

In block 108, the method 100 comprises determining an initial energy parameter, $E_i$, relating to an initial turn-on switching energy of the power semiconductor device 10, based on the initial transient current parameter, $I_{t,i}$, the initial transient voltage parameter, $V_{t,i}$. Optionally, the initial energy parameter is normalised to generate a normalised initial energy parameter, $E_{i,N}$, based on the initial load parameter.

Within block 101, are blocks 110 to 116. In block 110, the method 100 is similar to block 102 but differs in that an operating transient current parameter $I_{t,o}$, is received at a later time when the health state of the power semiconductor device 10 is not known, in other words, when the semiconductor device is operating.

In block 112, the method 100 is similar to block 104 but differs in that an operating transient voltage parameter $V_{t,o}$, is received at a later time when the semiconductor device 10 is turned on, and when the health state of the power semiconductor device 10 is not known, in other words, when the semiconductor device is operating.

In block 114, the method 100 is similar to block 106 but differs in that an operating load parameter is received at a later time when the health state of the power semiconductor device 10 is not known, in other words, when the semiconductor device is operating. The operating load parameter in this example includes an operating load current correction coefficient, $Id_{c,o}$, an operating load voltage correction coefficient, $Vd_{c,o}$, and an operating temperature correction coefficient $T_{c,o}$. In some examples, the method 100 may not include block 114.

In block 116, the method 100 is similar to block 108 but differs in that an operating energy parameter, $E_o$, relating to the turn-on switching energy of the power semiconductor device 10 in operation, is determined based on the operating transient current parameter, $I_{t,o}$, the operating transient voltage parameter, $V_{t,o}$. Optionally, the operating energy parameter is normalised to generate a normalised operating energy parameter, $E_{o,N}$, based on the operating load parameter.

In block 118, the method 100 comprises determining a health state of the power semiconductor device 10 based on the initial energy parameter $E_i$ or the normalised initial energy parameter $E_{i,N}$ and the operating energy parameter, $E_o$, or the normalised operating energy parameter, $E_{o,N}$.

Figure 3 is a flow chart showing more detailed steps of a method 200 of determining turn-on switching energy in blocks 108 and 116.

In block 202, the method 200 comprises integrating turn-on switching power over a predetermined time period, t.

For example, for the initial energy parameter, $E_i$, of the power semiconductor device 10, relating to an initial turn-on switching energy when the power semiconductor device 10 is known to be unaged, using equations (1)-(3) gives:

$$E_i = \int_0^t I_{t,i} V_{t,i} \, dt \qquad \text{Equation (5)}$$

For the operating energy parameter, $E_o$, of the power semiconductor device 10, relating to the turn-on switching energy of the semiconductor device 10, after a time period x, when the health state of the power semiconductor device is unknown, using equations (1)-(3) gives:

$$E_o = \int_x^{x+t} I_{t,o} V_{t,o} \, dt \qquad \text{Equation (6)}$$

In this example, in which the method 100 of Figure 2 includes block 106, the initial energy parameter, $E_i$, may be normalised using the initial load parameters including the initial load current correction coefficient, $Id_{c,i}$, the initial load voltage correction coefficient, $Vd_{c,i}$, and the initial temperature correction coefficient $T_{c,i}$, derived respectively from the monitored load current, the monitored load voltage and the monitored case temperature during turn-on, at the same time as the transient current is measured (i.e., when the semiconductor device 10 is known to be unaged). In an example where all of the load voltage, the load current and the case temperature are monitored, Equation (4) may be used to determine a normalised initial energy parameter, $E_{i,N}$, giving:

$$E_{i,N} = E_i \times Vd_{c,i} \times Id_{c,i} \times T_{c,i} \qquad \text{Equation (7)}$$

It will be appreciated that, in an example in which one of the load parameters is not monitored, there will be no corresponding correction coefficient in equation (7) to normalise the initial energy parameter.

In this example, in which the method includes block 114, the operating energy parameter, $E_o$, may also be normalised using the operating load parameters including the operating load current correction coefficient, $Id_{c,o}$, the operating load voltage correction coefficient, $Vd_{c,o}$, and the operating temperature correction coefficient $T_{c,o}$, derived respectively from the monitored load current, the monitored load voltage and the monitored case temperature during turn-on, at the same time as the operating transient current and the operating transient voltage is measured (i.e., when the health of the semiconductor device 10 is unknown). In an example where all of the load voltage, the load current and the case temperature are monitored, Equation (4) may be used to determine a normalised operating energy parameter, $E_{o,N}$, giving:

$$E_{o,N} = E_o \times Vd_{c,o} \times Id_{c,o} \times T_{c,o} \qquad \text{Equation (8)}$$

It will be appreciated that the correction coefficients may be integrated together with the transient current parameter and the transient voltage parameter if they vary significantly over the predetermined time period, t.

Preferably, the same type of correction coefficients are applied for normalising both the initial energy parameter and the operating energy parameter. For example, if only an initial temperature parameter is received, in block 106, and the normalised initial energy parameter $E_{i,N}$, is derived by normalising the initial energy parameter $E_i$, with only the initial temperature correction coefficient, $T_{c,i}$, (e.g., $E_{i,N} = E_i \times T_{c,i}$), then the normalised operating energy parameter $E_{o,N}$, should preferably also be derived by normalising the operating energy parameter $E_o$, with only the operating temperature correction coefficient $T_{c,o}$, (e.g., $E_{o,N} = E_o \times T_{c,o}$).

In block 204, the method 200 comprises determining a number of load current cycles over the predetermined time period, t. A load current cycle is defined as a fundamental frequency component of the system, in other words, the frequency of the resulting 3-phase current to the power consuming device 11....

In block 206, the method 200 comprises dividing the respective energy parameter, $E_i$, $E_o$, by the number of load current cycles over the respective predetermine period, t, to determine a respective initial load cycle energy parameter, $E_{i,\mu}$, and operating load cycle energy parameter, $E_{o,\mu}$, relating to an average energy loss for each load current cycle. The respective load cycle energy parameter, $E_\mu$, may be stored in a memory.

In block 208, the method 200 comprises determining whether there are more than a predetermined number, Y, of load cycle energy parameters, $E_\mu$, have been obtained (and optionally stored in the memory). If there are as many, or fewer load cycle energy parameters, $E_\mu$, than the predetermined number, then the method returns to block 202, and continues to monitor for a further predetermined time period, to obtain another load cycle energy parameter.

If, in block 208, the method 200 determines that more than the predetermined number, Y, of load cycle parameters have been obtained, the method proceeds to block 210.

In block 210, the method 200 comprises determining a peak load cycle energy parameter $E_{\mu,p}$, relating to a peak value of average energy loss for each load current cycle during the predetermined time period, and using this respectively as the initial energy parameter, $E_i$, and the operating energy parameter, $E_o$ in blocks 108 or 116 of Figure 2.

In other examples, the method 200 may not comprise blocks 208 and 210, and may instead base the initial energy parameter and operating energy parameter on the respective single load cycle energy parameter, $E_{i,\mu}$, $E_{o,\mu}$, determined in block 206.

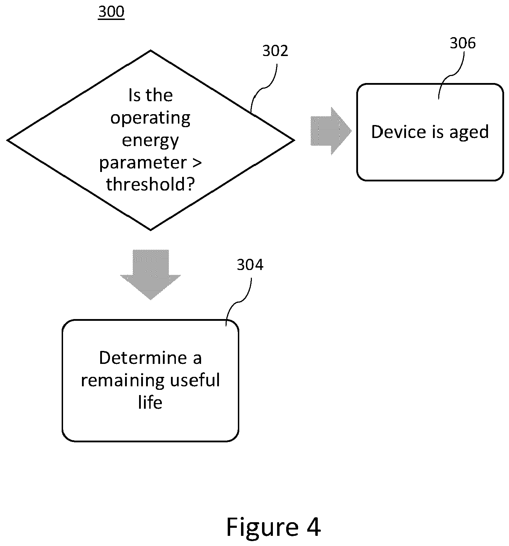

**Figure 4** is a flow chart showing more detailed steps of a method 300 of determining a health status of the semiconductor device 10, in block 118 of Figure 2.

In block 302, the method 300 comprises determining if the operating energy parameter, $E_o$, is above a threshold. The threshold may be based on the initial energy parameter. In this example, the threshold is 20% higher than the initial energy parameter, $E_i$. In other examples, the threshold may be any suitable amount above the initial energy parameter, $E_i$, such as 10% higher, 25% higher or 30% higher than the initial energy parameter, $E_i$.

If it is determined that the operating energy parameter, $E_o$, is above the threshold, the method 300 proceeds to block 304, in which the semiconductor device 10 is determined to be aged. An aged semiconductor device may be a semiconductor device which is no longer functional (i.e., failed), or which is close to failing.

If it is determined that the operating energy parameter, $E_o$, is not above the threshold, the method proceeds to block 306, in which the remaining useful life of the power semiconductor device 10 is determined, based on the initial energy parameter, $E_i$, and the operating energy parameter, $E_o$. The remaining useful life may be determined using a machine learning algorithm which has been trained with experimental data of energy parameter variation over a lifecycle of sample power semiconductor devices 10.

Although the external circuit 20 in the example described with reference to Figure 1 is connected to an inverter 10, in other examples, the external circuit 20 may be connected to any suitable power semiconductor device.

It will be understood that the invention is not limited to the embodiments above-described and various modifications and improvements can be made without departing from the concepts described herein. Except where mutually exclusive, any of the features may be employed separately or in combination with any other features and the disclosure extends to and includes all combinations and sub-combinations of one or more features described herein.

**Claims**

1. A method of monitoring a health state of a power semiconductor device, the method comprising:

   receiving an initial transient voltage parameter relating to a transient voltage of the power semiconductor device when turning on, when the power semiconductor device is known to be unaged;

receiving an initial transient current parameter relating to a transient current of the power semiconductor device when turning on, when the power semiconductor device is known to be unaged;

determining an initial energy parameter, relating to an initial turn-on switching energy or power of the power semiconductor device, when the power semiconductor device is known to be unaged, based on the initial transient voltage parameter and the initial transient current parameter;

receiving an operating transient voltage parameter relating to the transient voltage of the power semiconductor device in operation;

receiving an operating transient current parameter relating to the transient current of the power semiconductor device in operation;

determining an operating energy parameter, relating to the turn-on switching energy or power of the power semiconductor device in operation, based on the operating transient voltage parameter and the operating transient current parameter; and

determining the health state of the power semiconductor device based on the initial energy parameter and the operating energy parameter.

2. A method according to claim 1, wherein the health state of the power semiconductor device is determined to be aged if the operating energy parameter is above a threshold, the threshold being determined based on the initial energy parameter.

3. A method according to claim 2, wherein the threshold is at least 20% higher than the initial energy parameter.

4. A method according to any preceding claim, further comprising:

receiving an initial load parameter when the power semiconductor device is known to be unaged, and

receiving an operating load parameter parameter during operation of the power semiconductor device;

wherein the initial energy parameter is normalised based on the initial load parameter and the operating energy parameter is normalised based on the operating load parameter.

5. A method according to claim 4, wherein the load parameter comprises at least one of:

a temperature parameter relating to a temperature of the power semiconductor device;

a predetermined load voltage parameter relating to a load voltage which is applied to the power semiconductor device; and

a predetermined load current parameter relating to a load current which is applied to the power semiconductor device.

6. A method according to any precedeing claim, wherien the (i) initial energy parameter and the (ii) operating energy parameter are based respectively on (i) digitally integrating initial transient current parameter and initial transient voltage parameter and on (ii) digitally integrating operating transient current parameter and operating transient voltage parameter.

7. A method according to claim 6, wherein the operating energy parameter is determined by:

integrating turn-on switching power, based on the respective transient current parameter and transient voltage parameter, over a predetermined time period, to derive turn-on switching energy;

dividing the turn-on switching energy by a number of load current cycles over the predetermined time period to obtain a load cycle energy parameter, relating to an average energy loss for each load current cycle; and

basing the operating energy parameter on the average energy loss for each load current cycle.

8. A method according to claim 7, wherein basing the operating energy parameter on the average energy loss for each load current cycle comprises, identifying a plurality load cycle energy parameters over a predetermined time period, and basing the operating energy parameter on a peak load cycle energy parameter from the plurality of load cycle energy parameters, relating to a peak value of average energy loss for each load current cycle during the predetermined time period.

9. A method according to any preceding claim, further comprising:
determining a remaining useful life of the power semiconductor device based on the initial energy parameter and the operating energy parameter, using a machine learning algorithm which has been trained with experimental data of energy parameter variation over a lifecycle of sample power semiconductor devices.

10. An external circuit for connecting to a power semiconductor device, the external circuit comprising:

> a rogowski coil for measuring transient current;
> an analog isolator connected to a voltage sensor;
> a processor configured receive signals from the analog isolator and the rogowski coil and to perform a method in accordance with any preceding claim based on the received signals.

11. An external circuit according to claim 10, further comprising a gate driver configured to be connected between the analog isolator and a gate of the power semiconductor device, and configured to trigger initiation of voltage monitoring and current monitoring when the circuit is turned on.

12. An external circuit according to claim 10 or 11, further comprising a digital integration field-programmable gate array configured to receive signals from the analog isolator, and to integrate the signals for processing by the processor.

13. An external circuit according to any of claims 10-12, further comprising at least one temperature sensor configured to monitor the temperature of a case of the semiconductor device, and to deliver a signal indicative of the temperature of the case to the processor.

Figure 1

101     <u>100</u>                           103

102 —    **Receive initial transient current parameter**         **Receive operating transient current parameter** — 110

104 —    **Receive initial transient voltage parameter**         **Receive operating transient current parameter** — 112

106 —    **Receive initial load parameter**         **Receive operating load parameter** — 114

108 —    **Determine initial energy parameter**         **Determine operating energy parameter** — 116

**Determine the health state of the power semiconductor device**

118

## Figure 2

200

Integrate turn-on switching power over predetermined time period

202

Determine number of load current cycles over predetermined time period

204

Determine load cycle energy parameter

206

Obtained more than Y load cycle energy parameters?

208

no

yes

Determine peak load cycle energy parameter as operating energy parameter

210

Figure 3

300

302

306

Is the operating energy parameter > threshold?

Device is aged

304

Determine a remaining useful life

Figure 4

Europäisches
Patentamt

European
Patent Office

Office européen
des brevets

# EUROPEAN SEARCH REPORT

**Application Number**

EP 23 21 0692

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 067 967 A (UNIV SHANGHAI) 11 December 2020 (2020-12-11) | 1-7,9-13 | INV. G01R31/26 G01R31/28 G01R31/42 |
| A | * the whole document * | 8 | |
| A | US 2020/321766 A1 (NEYRET YANNICK [FR]) 8 October 2020 (2020-10-08) * paragraph [0099] * | 1-13 | |

**TECHNICAL FIELDS SEARCHED (IPC)**

G01R

The present search report has been drawn up for all claims

| Place of search | Date of completion of the search | Examiner |
|---|---|---|
| Munich | 18 April 2024 | Sedlmaier, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 0692

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2024

| Patent document cited in search report | | Publication date | Patent family member(s) | | Publication date |
|---|---|---|---|---|---|
| CN 112067967 | A | 11-12-2020 | NONE | | |
| US 2020321766 | A1 | 08-10-2020 | CN | 111799749 A | 20-10-2020 |
| | | | EP | 3719947 A1 | 07-10-2020 |
| | | | ES | 2924657 T3 | 10-10-2022 |
| | | | FR | 3094848 A1 | 09-10-2020 |
| | | | US | 2020321766 A1 | 08-10-2020 |

EPO FORM P0459

For more details about this annex : see Official Journal of the European Patent Office, No. 12/82

14